# EUROPÄISCHE PATENTSCHRIFT

(11) **EP 2 689 496 B1**
(45) Veröffentlichungstag und Bekanntmachung des Hinweises auf die Patenterteilung: **14.12.2016**
(21) Anmeldenummer: 12705668.7
(22) Anmeldetag: 23.02.2012
(51) Int. Cl.: H01R 12/89

(54) **DIREKTSTECKELEMENT, INSBESONDERE FÜR FAHRZEUGSTEUERGERÄTE**
DIRECT PLUG ELEMENT, IN PARTICULAR FOR VEHICLE CONTROL DEVICES
ÉLÉMENT D'ENFICHAGE DIRECT, EN PARTICULIER POUR APPAREILS DE COMMANDE DE VÉHICULE

(30) Priorität: 21.03.2011 DE 102011005858
(43) Veröffentlichungstag der Anmeldung: 29.01.2014
(73) Patentinhaber: Robert Bosch GmbH, 70442 Stuttgart (DE)
(72) Erfinder: PHILIPP, Eckhardt, 71701 Schwieberdingen (DE); HOFMEISTER, Werner, 75417 Muehlacker (DE)
(86) Internationale Anmeldenummer: PCT/EP2012/053038
(87) Internationale Veröffentlichungsnummer: WO 2012/126694

(56) Entgegenhaltungen:
- US-A- 4 080 027
- US-A- 4 629 270
- US-B1- 7 527 513
- US-E- R E33 604

## Beschreibung

### Stand der Technik

Die vorliegende Erfindung betrifft ein Direktsteckelement für eine verbesserte Mehrfach-Direktkontaktierung von elektrischen Bauteilen, wie z.B. Leiterplatten, wobei das Direktsteckelement insbesondere bei Steuergeräten von Fahrzeugen verwendet wird.

In jüngster Zeit werden vermehrt Direktsteckkontakte verwendet, bei denen ein Direktsteckelement unmittelbar auf eine Leiterplatte kontaktiert. Bei einer Vielzahl von Kontaktbereichen an der Leiterplatte werden die Kontaktbereiche dabei in einer Reihe nahe einer Leiterplattenkante angeordnet. Wenn hierbei viele Kontaktbereiche notwendig sind, ergibt sich eine entsprechende Länge an der Leiterplatte sowie eine komplizierte Verdrahtung auf der Leiterplatte. Ferner tritt bei der Verwendung von Direktsteckelementen in Fahrzeugen, beispielsweise zur Kontaktierung von Steuergeräten, das Problem auf, dass die Steckverbindungen Rüttelbewegungen ausgesetzt sind. Weiterhin können Kontakte verschleißen und sind dadurch elektrisch nicht stabil. Ferner ist zu beachten, dass eine Montagekraft zur Montage in das Direktsteckelement am Steuergerät nicht so hoch sein darf, um Beschädigungen am Steuergerät und/oder dem Direktsteckelement zu verhindern.

Das Dokument "US R E33 604 E" offenbart ein Direktsteckelement gemäß dem Oberbegriff des Patentanspruchs 1.

### Offenbarung der Erfindung

Die erfindungsgemäße Direktsteckelement mit den Merkmalen des Anspruchs 1 weist demgegenüber den Vorteil auf, dass einerseits eine Montage mit einer reduzierten Montagekraft möglich ist und andererseits eine sichere Verbindung zwischen dem Direktsteckelement und einer Trägerplatte, wie beispielsweise einer Leiterplatte eines Steuergeräts, möglich ist. Die reduzierte Montagekraft kann dabei derart eingestellt werden, dass eine nahezu kraftfreie Montage möglich ist. Ferner weist das erfindungsgemäße Direktsteckelement einen einfachen und kostengünstigen Aufbau auf und hat nur einen sehr geringen Platzbedarf. Dies wird erfindungsgemäß dadurch erreicht, dass das Direktsteckelement ein Gehäuse und einen zweiteiligen Kontaktträger umfasst. Der Kontaktträger weist ein erstes und ein zweites Kontaktträgerteil auf, wobei wenigstens einer der Kontaktträger ein Kontaktelement aufweist. Das Kontaktelement ist für einen Direktkontakt mit einem Kontaktbereich, z.B. ein Pad, an einer Trägerplatte z.B. eines Steuergeräts vorgesehen. Dabei sind die beiden Kontaktträgerteile lose, aber verliersicher, im Gehäuse des Direktsteckelements angeordnet. Ferner ist ein Schieber vorgesehen, welcher mit den Kontaktträgerteilen in Kontakt bringbar ist. Der Schieber bringt im montierten Zustand eine Vorspannung auf die beiden Kontaktträgerteile in einander entgegengesetzter Richtung auf, so dass die Kontaktträgerteile nicht mehr lose im Gehäuse angeordnet sind. Somit ist durch die losen Kontaktträgerteile im Gehäuse eine ohne großen Kraftaufwand einfache Montage möglich. Die losen Kontaktträgerteile werden bei der Montage einer Leiterplatte oder dgl. einfach zur Seite geschoben. Erfindungsgemäß sind die Kontaktträgerteile dabei derart lose im Gehäuse angeordnet, dass sie nicht von selbst herausfallen können, was beispielsweise mittels Vorsprüngen oder Ähnlichem am Gehäuse ermöglicht werden kann. Ferner sind die beiden Kontaktträgerteile im Gehäuse nur in einem gewissen Umfang lose angeordnet, so dass die Kontaktträgerteile auch im losen Zustand immer eine vorbestimmte Ausrichtung aufweisen und ihre Position nur in einem vorbestimmten, definierten Umfang verändert werden kann. Nachdem die Direktsteckverbindung ausgeführt ist, wird dann erfindungsgemäß eine Position eines Schiebers durch Drücken oder Ziehen derart verändert, dass der Schieber mit den Kontaktträgerteilen in Kontakt kommt und die Vorspannung auf die Kontaktträgerteile ausübt. Hierdurch wird ein sicherer Kontakt zwischen dem Direktsteckelement und den Kontaktbereichen an der Trägerplatte erreicht.

Die Unteransprüche zeigen bevorzugte Weiterbildungen der Erfindung.

Vorzugsweise ist zwischen den beiden Kontaktträgerteilen ein sich erweiternder Schlitz, insbesondere ein sich konisch erweiternder Schlitz, vorgesehen. Hierdurch ist schon eine leichte Vorfixierung einer in den Schlitz eingeschobenen Trägerplatte möglich.

Besonders bevorzugt umfasst der Schieber eine Vielzahl von vorstehenden Nasen, welche mit den Kontaktträgerteilen in Kontakt bringbar sind, um diese vorzuspannen. Für eine einfachere Bewegbarkeit des Schiebers weisen die Nasen vorzugsweise Anlaufschrägen auf.

Besonders bevorzugt umfasst der Schieber einen ersten Arm und einen zweiten Arm, welche an einem Endbereich miteinander verbunden sind, wobei die vorstehenden Nasen an nach innen gerichteten Bereichen der Arme angeordnet sind. Besonders bevorzugt sind dabei die Nasen an den beiden Armen in Bewegungsrichtung des Schiebers an gleichen Positionen vorgesehen, um die beiden losen Kontaktträgerteile durch die vorstehenden Nasen zwischen sich mit einer vorbestimmten Vorspannkraft einzuspannen.

Um die Gefahr eines unbeabsichtigten Lösens des Direktsteckelements weiter zu reduzieren, umfasst das Direktsteckelement vorzugsweise eine Rastvorrichtung, um den Schieber am Gehäuse zu verrasten. Die Rastvorrichtung ist vorzugsweise eine Clipsverbindung.

Um eine möglichst gute Vorspannkraft selbst bei höheren Fertigungstoleranzen auf die beiden Kontaktträgerteile zu erreichen, sind vorzugsweise zusätzlich Federelemente an den beiden Kontaktträgerteilen angeordnet, wobei die Federelemente zwischen dem Kontaktträgerteil und dem Schieber vorgesehen sind. Hierdurch kann durch eine Bewegung des Schiebers erreicht werden, dass die vorstehenden Nasen des Schiebers auf die Federelemente auflaufen und die Vorspannkraft über die Federelemente auf die Kontaktträgerteile übertragen wird. Die Federelemente sind vorzugsweise aus Blech, insbesondere aus Federblech, hergestellt.

Besonders bevorzugt ist ein Gesamtspiel der lose im Gehäuse angeordneten Kontaktträgerteile in alle Richtungen maximal so groß wie eine maximale Dicke eines Kontaktträgerteils oder einer Trägerplatte in eine Richtung senkrecht zu einer Einschubrichtung der Trägerplatte.

Weiter bevorzugt ist der Schieber derart angeordnet, dass durch eine Bewegung des Schiebers mindestens ein Kontaktträgerteil, vorzugsweise beide Kontaktträgerteile, verschiebbar ist. Weiterhin ist ein modularer Aufbau möglich, z.B. ist ein Kontaktträgerteil größer als das andere Kontaktträgerteil.

Ferner betrifft die vorliegende Erfindung eine elektrische Anordnung, umfassend ein erfindungsgemäßes Direktsteckelement und eine Trägerplatte, insbesondere eine Leiterplatte, mit freiliegenden Kontaktbereichen. Im montierten Zustand sind dabei die freiliegenden Kontaktbereiche zwischen den Kontaktträgerteilen angeordnet und kommen mit Direktkontakten der Kontaktträgerteile unmittelbar in Kontakt. Hierdurch ist die elektrische Kontaktierung der Trägerplatte sichergestellt.

Ferner betrifft die vorliegende Erfindung ein Steuergerät für ein Fahrzeug, welches ein erfindungsgemäßes Direktsteckelement umfasst. Das Steuergerät ist insbesondere zur Kraftstoffeinspritzung eingerichtet.

### Zeichnung

Nachfolgend wird unter Bezugnahme auf die begleitende Zeichnung ein Ausführungsbeispiel der Erfindung im Detail beschrieben. In der Zeichnung ist:
- Figur 1: eine schematische Draufsicht auf ein Direktsteckelement, welches an einem Steuergerät für ein Fahrzeug aufgesteckt ist;
- Figur 2: eine schematische Schnittansicht entlang der Linie II-II von Figur 1 mit montierter Leiterplatte;
- Figur 3: eine schematische Schnittansicht entlang der Linie III-III von Figur 1 mit montierter Leiterplatte; und
- Figur 4: eine schematische Schnittansicht des Direktsteckelements von Figur 1, welche den Montagevorgang der Leiterplatte andeutet.

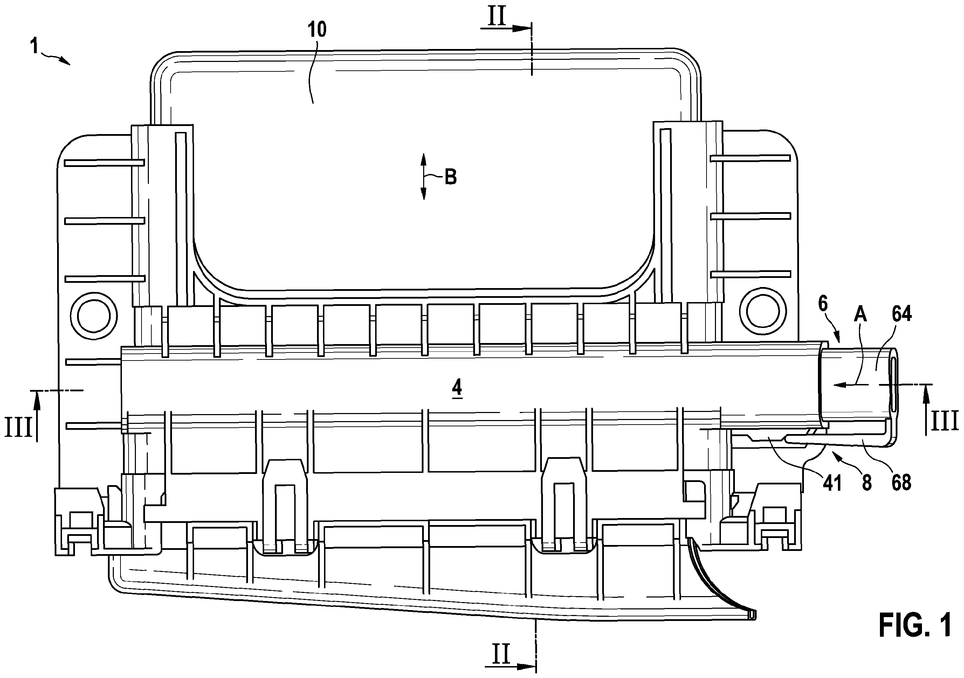

Bevorzugte Ausführungsform der Erfindung Nachfolgend wird unter Bezugnahme auf die Figuren 1 bis 4 eine elektrische Anordnung 1 und ein Direktsteckelement 3 gemäß einem Ausführungsbeispiel der Erfindung im Detail beschrieben.

Das erfindungsgemäße Direktsteckelement 3 umfasst ein Gehäuse, vorzugsweise aus Kunststoff, und einen im Gehäuse 4 angeordneten zweiteiligen Kontaktträger 5. Der Kontaktträger 5 umfasst ein erstes Kontaktträgerteil 51 und ein zweites Kontaktträgerteil 52. Die Kontaktträgerteile 51, 52 sind lose im Gehäuse angeordnet. Nicht gezeigte Vorsprünge im Gehäuse verhindern dabei, dass die lose angeordneten Kontaktträgerteile 51, 52 aus dem Gehäuse 4 herausfallen. Ein Spiel der lose angeordneten Kontaktträgerteile 51, 52 im Gehäuse 4 ist dabei derart, dass die Kontaktträgerteile 51, 52 keine grundsätzlichen Richtungsänderungen, z.B. Drehungen um 360° in waagrechter und senkrechter Richtung, ausführen können, sondern ihre Hauptausrichtung beibehalten. An den Kontaktträgerteilen 51, 52 sind jeweils eine Vielzahl von Direktkontakten 53 angeordnet, welche direkt mit Kontaktbereichen 20 an einer Trägerplatte 2, beispielsweise einer Leiterplatte, einen elektrischen Kontakt herstellen können.

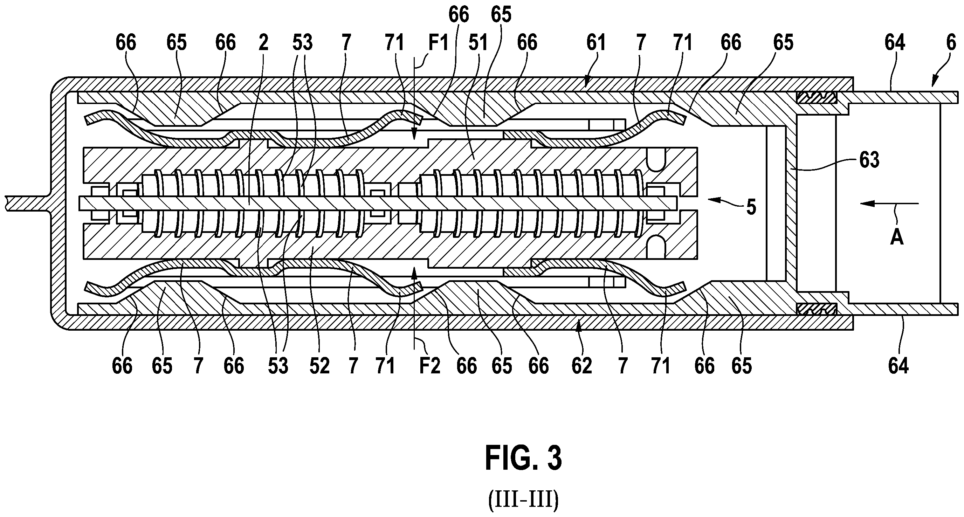

Das Direktsteckelement 3 umfasst ferner einen Schieber 6. Der Schieber 6 ist von Hand betätigbar und weist einen ersten Arm 61 und einen zweiten Arm 62 auf (vgl. Figur 3). Die beiden Arme 61, 62 sind über einen Verbindungsbereich 63 an einem Ende des Schiebers 6 miteinander verbunden. Ferner sind außerhalb des Gehäuses 4 Handangriffsflächen 64 vorgesehen, um eine manuelle Betätigung des Schiebers 6 zu ermöglichen. Weiterhin umfasst der Schieber 6 eine Vielzahl von vorstehenden Nasen 65, welche an nach innen gerichteten Bereichen der Arme 61, 62 angeordnet sind. An jeder der Nasen 65 ist wenigstens eine Anlaufschräge 66 vorgesehen.

Wie in den Figuren 1 und 3 durch den Pfeil A angedeutet, kann der Schieber 6 manuell quer zu einer Kontaktrichtung B verschoben werden.

Das in diesem Ausführungsbeispiel gezeigte Direktsteckelement 3 wird zum Herstellen einer Direktsteckverbindung mit einem Steuergerät 10 eines Fahrzeugs eingesetzt.

Ferner sind am Kontaktträger 5 eine Vielzahl von Federelementen 7 aus einem elastischen Federblech befestigt. Die Federelemente 7 weisen jeweils geschwungen ausgebildete, freie Endbereiche 71 auf, welche mit den Anlaufschrägen 66 der Nasen 65 am Schieber 6 bei Einschieben des Schiebers in Richtung A in Kontakt kommen. Hierdurch wird nach dem Einschieben des Schiebers 6 in Richtung A eine erste Vorspannkraft F1 auf das erste Kontaktträgerteil 51 ausgeübt, und eine zweite Vorspannkraft F2, welche entgegengesetzt zur Vorspannkraft F1 gerichtet ist, wird auf das zweite Kontaktträgerteil 52 ausgeübt. Figur 3 zeigt dabei den Zustand, bei dem die Trägerplatte 2 schon in den Kontaktträger 5 eingeschoben ist, jedoch der Schieber 6 noch nicht in Richtung des Pfeils A bewegt wurde.

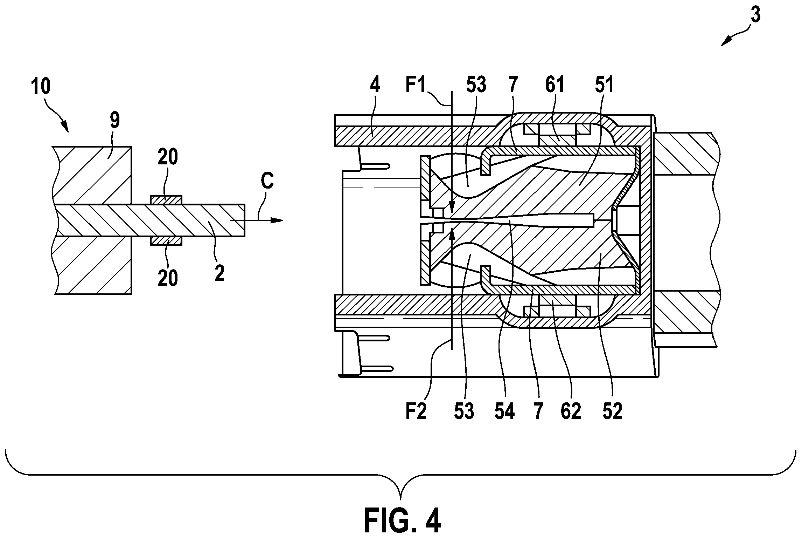

Wie aus Figur 4 gezeigt, ist in dem Zustand, in welchem die Trägerplatte 2 noch nicht in das Direktsteckelement 3 eingeführt ist, zwischen dem ersten und zweiten Kontaktträgerteil 51, 52 ein Schlitz 54 gebildet, welcher sich in Einführungsrichtung C konisch erweitert. Durch diesen sich konisch erweiternden Schlitz wird erreicht, dass, wenn wie in Figur 4 angedeutet, die Trägerplatte 2 in Einführrichtung C zwischen die beiden Kontaktträgerteile 51, 52 eingeführt wird, die Kontaktträgerteile 51, 52 leicht gegen die Innenwand des Gehäuses 4 gedrückt werden, so dass eine Vorfixierung der Leiterplatte im Direktsteckelement 3 ermöglicht wird. Anschließend wird dann der Schieber 6 eingeschoben, so dass eine definierte Vorspannung über die Nasen 65 und die Federelemente 7 auf die Kontaktträgerteile 51, 52 ausgeübt wird.

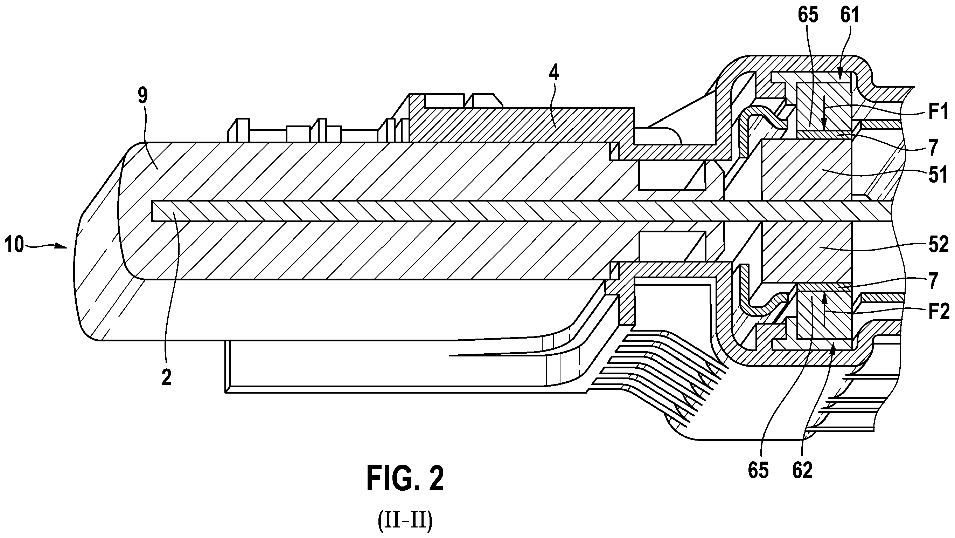

Somit liegen dann im eingeschobenen Zustand der Trägerplatte 2 die Direktkontakte 53 mit Vorspannung auf den Kontaktbereichen 20 der Trägerplatte auf, so dass ein sicherer elektrischer Kontakt vorhanden ist. Figur 2 zeigt den eingeschobenen Zustand des Schiebers 6. Dabei drücken die Nasen 65 über die Federelemente 7 gegen die Kontaktträgerteile 51, 52, so dass die Trägerplatte 2 zwischen den Kontaktträgerteilen 51, 52 eingeklemmt wird.

Um insbesondere bei einem Einsatz in einem Fahrzeug zu verhindern, dass sich durch Rüttelbewegungen oder dgl. die Steckverbindung wieder löst, ist ferner eine Rastvorrichtung 8 zwischen dem Schieber 6 und dem Gehäuse 4 vorgesehen. Wie aus Figur 1 ersichtlich ist, umfasst die Rastvorrichtung 8 einen am Gehäuse 4 einstückig gebildeten Vorsprung 41 und einen am Schieber 6 angeordneten Rastbügel 68 auf, wobei der Rastbügel nach dem Einschieben des Schiebers 6 hinter den Vorsprung 41 greift und die eingeschobene Position des Schiebers 6 somit verrastet ist. Hierdurch kann ein ungewolltes Lösen des Schiebers 6 und damit ein Lösen des Direktsteckelements 3 von der Trägerplatte 2 sicher verhindert werden.

Somit kann erfindungsgemäß zuerst die Trägerplatte 2 mit nur geringem Kraftaufwand zwischen die lose im Gehäuse 4 befindlichen Kontaktträgerteile 51, 52 eingeschoben werden. Durch den sich konisch erweiternden Schlitz zwischen den beiden Kontaktträgerteilen 51, 52 kann eine erste Vorfixierung der Trägerplatte ermöglicht werden. Anschließend wird dann der Schieber 6 in Richtung des Pfeils A eingeschoben, so dass die Vorspannung F1, F2 auf die Kontaktträgerteile 51, 52 ausgeübt wird. Dabei erfolgt gleichzeitig noch eine Sicherung des Schiebers 6 durch die Rastvorrichtung 8. Zum Lösen der Direktsteckverbindung wird zuerst die Rastvorrichtung 8 gelöst und der Schieber 6 aus dem Gehäuse 4 wieder teilweise herausgezogen. Dadurch entfällt die Vorspannkraft auf die Kontaktträgerteile 51, 52, so dass die Trägerplatte 2 ohne großen Kraftaufwand wieder aus dem Direktsteckelement 3 herausgezogen werden kann.

Es sei ferner angemerkt, dass zwischen dem Schieber 6 und dem Gehäuse 4 auch eine separate Abdichtung vorgesehen sein kann, um das Eindringen von Feuchtigkeit usw. von außen in die Steckverbindung zu vermeiden.

## Patentansprüche

1. Direktsteckelement für das elektrische Kontaktieren einer in das Direktsteckelement einführbaren Trägerplatte, das Direktsteckelement umfassend:
- einen zweiteiligen Kontaktträger (5) mit einem ersten Kontaktträgerteil (51) und einem zweiten Kontaktträgerteil (52), wobei wenigstens einer der Kontaktträger (51, 52) einen Direktkontakt (53) aufweist, und
- einen Schieber (6), welcher mit den Kontaktträgerteilen (51, 52) in Kontakt bringbar ist, wobei im Kontaktzustand durch den Schieber (6) eine erste Vorspannkraft (F1) auf das erste Kontaktträgerteil (51) in einer ersten Richtung und eine Vorspannkraft (F2) auf das zweite Kontaktträgerteil (52) in einer zweiten Richtung, im Wesentlichen entgegensetzt der ersten Richtung, vorhanden ist,
wobei das Direktsteckelement weiterhin ein Gehäuse (4) umfasst,
**dadurch gekennzeichnet,**
**dass** die beiden Kontaktträgerteile (51, 52) ohne montierten Schieber (6) lose im Gehäuse (4) angeordnet sind, so dass ein Gesamtspiel der lose im Gehäuse (4) angeordneten Kontaktträgerteile (51, 52) in alle Richtungen maximal so groß wie eine maximale Dicke eines der Kontaktträgerteile oder einer in das Direktsteckelement einführbaren Trägerplatte (2) in einer Richtung senkrecht zu einer Einschubrichtung (C) der Trägerplatte (2), und dass die beiden Kontaktträgerteile (51, 52) ohne montierten Schieber (6) gleichzeitig unverlierbar im Gehäuse angeordnet sind.

2. Direktsteckelement nach Anspruch 1, **dadurch gekennzeichnet, dass** zwischen den beiden Kontaktträgerteilen (51, 52) ein sich erweiternder Schlitz (54), insbesondere sich konisch erweiternder Schlitz, vorgesehen ist.

3. Direktsteckelement nach einem der vorhergehenden Ansprüche, **dadurch gekennzeichnet, dass** der Schieber (6) eine Vielzahl von vorstehenden Nasen (65) aufweist, welche mit dem ersten und/oder zweiten Kontaktträgerteil (51, 52) in Kontakt bringbar sind, um die Kontaktträgerteile vorzuspannen.

4. Direktsteckelement nach Anspruch 3, **dadurch gekennzeichnet, dass** an den vorstehenden Nasen (65) Anlaufschrägen (66) ausgebildet sind.

5. Direktsteckelement nach Anspruch 3 oder 4, **dadurch gekennzeichnet, dass** der Schieber (6) einen ersten Arm (61) und einen zweiten Arm (62) umfasst, welche durch einen Endbereich (63) miteinander verbunden sind, wobei die vorstehenden Nasen (65) an nach innen gerichteten Bereichen der Arme (61, 62) angeordnet sind.

6. Direktsteckelement nach einem der vorhergehenden Ansprüche, **gekennzeichnet durch** eine Rastvorrichtung (8), um den Schieber (6) im Kontaktzustand am Gehäuse (4) zu verrasten.

7. Direktsteckelement nach einem der vorhergehenden Ansprüche, **gekennzeichnet durch** eine Vielzahl von Federelementen (7), welche am ersten und zweiten Kontaktträgerteil (51, 52) für eine Kraftübertragung in Verbindung mit dem Schieber (6) angeordnet sind.

8. Direktsteckelement nach Anspruch 7, **dadurch gekennzeichnet, dass** die Federelemente (7) aus einem Blech, insbesondere einem Federblech, hergestellt sind.

9. Elektrische Anordnung (1), umfassend ein Direktsteckelement (3) nach einem der vorhergehenden Ansprüche, und eine Trägerplatte (2) mit an der Trägerplatte freiliegenden Kontaktbereichen (20), wobei die freiliegenden Kontaktbereiche (20) im Kontaktzustand zwischen den Kontaktträgerteilen (51, 52) angeordnet ist.

10. Anordnung nach Anspruch 9, wobei die Trägerplatte Teil eines Steuergeräts (10) für ein Fahrzeug ist.

## Claims

1. Direct plug-in element for making electrical contact with a carrier plate which can be inserted into the direct plug-in element, the direct plug-in element comprising:
- a two-part contact carrier (5) having a first contact carrier part (51) and a second contact carrier part (52), wherein at least one of the contact carriers (51, 52) has a direct contact (53), and
- a slide (6) which can be brought into contact with the contact carrier parts (51, 52), wherein, in the contact state, a first pretensioning force (F1) is applied to the first contact carrier part (51) in a first direction and a pretensioning force (F2) is applied to the second contact carrier part (52) in a second direction, substantially opposite to the first direction, by the slide (6),
wherein the direct plug-in element further comprises a housing (4),
**characterized**
**in that** the two contact carrier parts (51, 52) are arranged loosely in the housing (4) when the slide (6) is not fitted, so that a total play of the contact carrier parts (51, 52), which are arranged loosely in the housing (4), in all directions is at most as high as a maximum thickness of one of the contact carrier parts or a carrier plate (2), which can be inserted into the direct plug-in element, in a direction perpendicular to an insertion direction (C) of the carrier plate (2), and in that the two contact carrier parts (51, 52) are at the same time arranged in a captive manner in the housing when the slide (6) is not fitted.

2. Direct plug-in element according to Claim 1, **characterized in that** a widening slot (54), in particular a conically widening slot, is provided between the two contact carrier parts (51, 52).

3. Direct plug-in element according to either of the preceding claims, **characterized in that** the slide (6) has a plurality of projecting lugs (65) which can be brought into contact with the first and/or second contact carrier part (51, 52) in order to prestress the contact carrier parts.

4. Direct plug-in element according to Claim 3, **characterized in that** run-on bevels (66) are formed on the projecting lugs (65).

5. Direct plug-in element according to Claim 3 or 4, **characterized in that** the slide (6) comprises a first arm (61) and a second arm (62) which are connected to one another by an end region (63), wherein the projecting lugs (65) are arranged on inwardly directed regions of the arms (61, 62).

6. Direct plug-in element according to one of the preceding claims, **characterized by** a latching apparatus (8) in order to lock the slide (6) to the housing (4) in the contact state.

7. Direct plug-in element according to one of the preceding claims, **characterized by** a plurality of spring elements (7) which are arranged on the first and second contact carrier part (51, 52) for force transmission in connection with the slide (6).

8. Direct plug-in element according to Claim 7, **characterized in that** the spring elements (7) are produced from a metal sheet, in particular a spring metal sheet.

9. Electrical arrangement (1) comprising a direct plug-in element (3) according to one of the preceding claims, and a carrier plate (2) having contact regions (20) which are exposed on the carrier plate, wherein the exposed contact regions (20) is arranged between the contact carrier parts (51, 52) in the contact state.

10. Arrangement according to Claim 9, wherein the carrier plate is part of a controller (10) for a vehicle.

## Revendications

1. Elément d'enfichage direct pour le contact électrique d'une plaque de support pouvant être introduite dans l'élément d'enfichage direct, l'élément d'enfichage direct comprenant :
- un support de contact en deux parties (5) avec une première partie de support de contact (51) et une deuxième partie de support de contact (52), au moins l'un des supports de contact (51, 52) présentant un contact direct (53), et
- un coulisseau (6) qui peut être amené en contact avec les parties de support de contact (51, 52), une première force de précontrainte (F1), dans l'état de contact, étant appliquée par le coulisseau (6) sur la première partie de support de contact (51) dans une première direction et une force de précontrainte (F2) étant appliquée sur la deuxième partie de support de contact (52) dans une deuxième direction, essentiellement opposée à la première direction,
l'élément d'enfichage direct comprenant en outre un boîtier (4),
**caractérisé en ce que** les deux parties de support de contact (51, 52), sans le coulisseau (6) monté, sont disposées lâchement dans le boîtier (4), de telle sorte qu'un jeu total des parties de support de contact (51, 52) disposées lâchement dans le boîtier (4) dans toutes les directions soit au maximum aussi grand qu'une épaisseur maximale de l'une des parties de support de contact ou d'une plaque de support (2) pouvant être introduite dans l'élément d'enfichage direct dans une direction perpendiculaire à une direction d'enfoncement (C) de la plaque de support (2), et **en ce que** les deux parties de support de contact (51, 52), sans le coulisseau (6) monté, sont disposées simultanément de manière imperdable dans le boîtier.

2. Élément d'enfichage direct selon la revendication 1, **caractérisé en ce qu'**entre les deux parties de support de contact (51, 52) est prévue une fente s'élargissant (54), en particulier une fente s'élargissant de manière conique.

3. Élément d'enfichage direct selon l'une quelconque des revendications précédentes, **caractérisé en ce que** le coulisseau (6) présente une pluralité d'ergots saillants (65) qui peuvent être amenés en contact avec la première et/ou la deuxième partie de support de contact (51, 52) afin de précontraindre les parties de support de contact.

4. Élément d'enfichage direct selon la revendication 3, **caractérisé en ce que** des biseaux de montée (66) sont réalisés sur les ergots saillants (65).

5. Élément d'enfichage direct selon la revendication 3 ou 4, **caractérisé en ce que** le coulisseau (6) comprend un premier bras (61) et un deuxième bras (62), lesquels sont connectés l'un à l'autre par une région d'extrémité (63), les ergots saillants (65) étant disposés au niveau de régions des bras (61, 62) orientées vers l'intérieur.

6. Élément d'enfichage direct selon l'une quelconque des revendications précédentes, **caractérisé par** un dispositif d'encliquetage (8), afin d'encliqueter le coulisseau (6) dans l'état de contact au niveau du boîtier (4).

7. Élément d'enfichage direct selon l'une quelconque des revendications précédentes, **caractérisé par** une pluralité d'éléments de ressort (7) qui sont disposés sur la première et la deuxième partie de support de contact (51, 52) pour un transfert de force en liaison avec le coulisseau (6).

8. Élément d'enfichage direct selon la revendication 7, **caractérisé en ce que** les éléments de ressort (7) sont fabriqués à partir d'une tôle, en particulier d'une tôle à ressort.

9. Agencement électrique (1), comprenant un élément d'enfichage direct (3) selon l'une quelconque des revendications précédentes, et une plaque de support (2) avec des régions de contact (20) exposées au niveau de la plaque de support, les régions de contact exposées (20) étant disposées dans l'état de contact entre les parties de support de contact (51, 52).

10. Agencement selon la revendication 9, dans lequel la plaque de support fait partie d'un appareil de commande (10) pour un véhicule.
